# EUROPEAN PATENT APPLICATION

(11) **EP 4 597 133 A1**
(43) Date of publication of application: **06.08.2025**
(21) Application number: 25155315.2
(22) Date of filing: 31.01.2025
(51) Int. Cl.: G01R 31/367, G01R 31/392

(54) **APPARATUS AND METHOD FOR DIAGNOSING BATTERY**

(30) Priority: 31.01.2024 KR 20240015252
(71) Applicant: LG Energy Solution, Ltd., Seoul 07335 (KR)
(72) Inventor: KIM, Young-Deok, 34122 Daejeon (KR); KIM, Dong-Hyun, 34122 Daejeon (KR); KIM, Ji-Yeon, 34122 Daejeon (KR); KIM, Tae-Hyeon, 34122 Daejeon (KR); PARK, Jun-Cheol, 34122 Daejeon (KR); YOON, Seo-Young, 34122 Daejeon (KR); CHOI, Soon-Ju, 34122 Daejeon (KR); CHOI, Soon-Hyung, 34122 Daejeon (KR); CHOI, Hyun-Jun, 34122 Daejeon (KR)
(74) Representative: Goddar, Heinz J.

(57) **Abstract**

The apparatus for diagnosing a battery according to the present disclosure includes a profile obtaining unit configured to obtain a battery profile representing a correspondence relationship between voltage and capacity of a battery; a profile adjusting unit configured to adjust a preset reference positive electrode profile and a reference negative electrode profile to correspond to the battery profile to generate an adjusted positive electrode profile and an adjusted negative electrode profile; and a control unit configured to extract a diagnostic factor for the battery from at least one of the adjusted positive electrode profile and the adjusted negative electrode profile and diagnose a state of the battery based on the extracted diagnostic factor.

## Description

### TECHNICAL FIELD

This application is based on and claims priority from Korean Patent Application No. 10-2024-0015252, filed on January 31, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve one or more of the problems of the related art. Therefore, some aspects of the present disclosure are directed to providing an apparatus and method for diagnosing a battery, which non-destructively diagnoses a state of a battery. In the present disclosure, the battery may be a secondary battery and may also be denoted a rechargeable battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to a first aspect of the present disclosure may comprise a profile obtaining unit configured to obtain a battery profile representing a correspondence relationship between voltage and capacity of a battery; a profile adjusting unit configured to adjust a preset reference positive electrode profile and a reference negative electrode profile to correspond to the battery profile to generate an adjusted positive electrode profile and an adjusted negative electrode profile; and a control unit configured to extract a diagnostic factor for the battery from at least one of the adjusted positive electrode profile and the adjusted negative electrode profile and diagnose a state of the battery based on the extracted diagnostic factor.

The control unit may be configured to calculate a degradation parameter. The degradation parameter may for example include at least one of an available lithium loss rate, a positive electrode loss rate, a negative electrode loss rate, and a capacity loss rate based on the extracted diagnostic factor. The control unit may be further configured to diagnose the state of the battery based on the calculated degradation parameter.

The control unit may be configured to determine a first feature value from the adjusted positive electrode profile and to determine or calculate the available lithium loss rate based on the first feature value, a preset first reference feature value, and a preset reference difference value.

The control unit may be configured to compare the available lithium loss rate with a preset first threshold value and to diagnose the state of the battery as an available lithium loss state based on the comparison result.

The control unit may be configured to determine a second feature value from the adjusted positive electrode profile and to determine or calculate the positive electrode loss rate based on the second feature value, a preset second reference feature value, and a preset reference difference value.

The control unit may be configured to determine or calculate a positive electrode change rate of the adjusted positive electrode profile and calculate the positive electrode loss rate based on the positive electrode change rate and a preset reference positive electrode change rate.

The control unit may be configured to compare the positive electrode loss rate with a preset second threshold value and to diagnose the state of the battery as a positive electrode loss state based on the comparison result.

The control unit may be configured to determine or calculate a negative electrode change rate of the adjusted negative electrode profile and calculate the negative electrode loss rate based on the negative electrode change rate and a preset reference negative electrode change rate.

The control unit may be configured to compare the negative electrode loss rate with a preset third threshold value and to diagnose the state of the battery as a negative electrode loss state based on the comparison result.

The control unit may be configured to determine a first feature value and a second feature value from the adjusted positive electrode profile and determine or calculate the capacity loss rate based on the first feature value, the second feature value, and a preset reference difference value.

The control unit may be configured to determine a third feature value and a fourth feature value from the adjusted negative electrode profile and determine or calculate the capacity loss rate based on the third feature value, the fourth feature value, and a preset reference difference value.

The control unit may be configured to compare the capacity loss rate with a preset fourth threshold value and to diagnose the state of the battery as a capacity loss state based on the comparison result.

A battery pack according to a second of the present disclosure may comprise the apparatus for diagnosing a battery according to one of the embodiments of the first aspect of the present disclosure.

A vehicle according to a third aspect of the present disclosure may comprise the apparatus for diagnosing a battery according to one of the embodiments of the first aspect of the present disclosure.

A method for diagnosing a battery according to a fourth aspect of the present disclosure may comprise a profile obtaining step of obtaining a battery profile representing a correspondence relationship between voltage and capacity of a battery; a profile adjusting step of adjusting a preset reference positive electrode profile and a reference negative electrode profile to correspond to the battery profile to generate an adjusted positive electrode profile and an adjusted negative electrode profile; a diagnostic factor extracting step of extracting a diagnostic factor for the battery from at least one of the adjusted positive electrode profile and the adjusted negative electrode profile; and a diagnosing step of diagnosing a state of the battery based on the extracted diagnostic factor.

The method may further comprise operations performed by the apparatus for diagnosing a battery according to one of the embodiments of the first aspect of the present disclosure.

One or more computer readable media according to a fifth aspect of the present disclosure may store instructions that, when executed by one or more processing units (e.g. provided in an apparatus for diagnosing a battery), cause the one or more processing units to diagnose a battery by executing a profile obtaining step of obtaining a battery profile representing a correspondence relationship between voltage and capacity of a battery; a profile adjusting step of adjusting a preset reference positive electrode profile and a reference negative electrode profile to correspond to the battery profile to generate an adjusted positive electrode profile and an adjusted negative electrode profile; a diagnostic factor extracting step of extracting a diagnostic factor for the battery from at least one of the adjusted positive electrode profile and the adjusted negative electrode profile; and a diagnosing step of diagnosing a state of the battery based on the extracted diagnostic factor.

The one or more computer readable media may further store instructions that, when executed by the one or more processing units, may cause the one or more processing units to perform the operations of the apparatus for diagnosing a battery according to one of the embodiments of the first aspect of the present disclosure.

A computer program according to a sixths aspect of the present disclosure, when executed by one or more processing units, cause the one or more processing units (e.g. provided in an apparatus for diagnosing a battery) to diagnose a battery by executing a profile obtaining step of obtaining a battery profile representing a correspondence relationship between voltage and capacity of a battery; a profile adjusting step of adjusting a preset reference positive electrode profile and a reference negative electrode profile to correspond to the battery profile to generate an adjusted positive electrode profile and an adjusted negative electrode profile; a diagnostic factor extracting step of extracting a diagnostic factor for the battery from at least one of the adjusted positive electrode profile and the adjusted negative electrode profile; and a diagnosing step of diagnosing a state of the battery based on the extracted diagnostic factor.

The computer program, when executed by the one or more processing units, may cause the one or more processing units to perform the operations of the apparatus for diagnosing a battery according to one of the embodiments of the first aspect of the present disclosure.

### Advantageous Effects

According to an embodiment of the present disclosure, the apparatus for diagnosing a battery may non-destructively estimate a positive electrode profile and a negative electrode profile of a battery, and distinguish and/or diagnose the state of the battery based on the estimated positive electrode profile and negative electrode profile.

That is, the apparatus for diagnosing a battery has the advantage of being able to generate a positive/negative electrode profile that reflects the current state of the battery, and also being able to diagnose the state of the battery very specifically.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a drawing schematically showing an adjustment result of a reference positive electrode profile and a reference negative electrode profile according to an embodiment of the present disclosure.
FIG. 3 is a drawing schematically showing a battery profile and a reference full-cell profile according to an embodiment of the present disclosure.
FIG. 4 is a drawing schematically showing a degradation parameter according to an embodiment of the present disclosure.
FIG. 5 is a drawing schematically showing a battery pack according to another embodiment of the present disclosure.
FIG. 6 is a drawing schematically showing a vehicle according to another embodiment of the present disclosure.
FIG. 7 is a diagram schematically showing a method for diagnosing a battery according to still another embodiment of the present disclosure.

### DETAILED DESCRIPTION

It should be understood that the terms used in the specification and the appended claims should not be construed as limited to their general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another element among various elements, but not intended to limit the elements by the terms.

Throughout the specification, when a portion is referred to as "comprising" or "including" any element, it means that the portion may further include other elements, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, embodiments of the present disclosure will be described in detail with reference to the accompanying drawings.

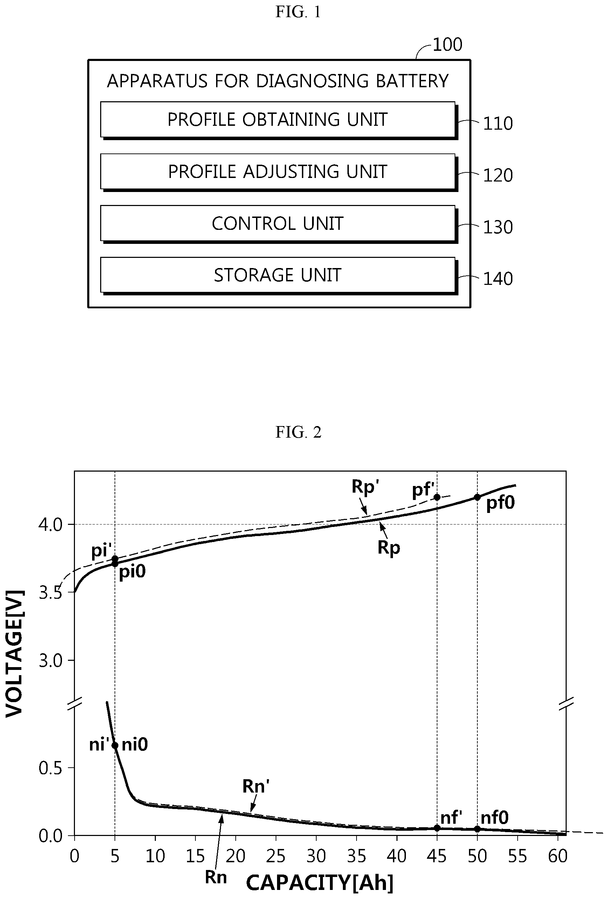

FIG. 1 is a diagram schematically illustrating an apparatus 100 for diagnosing a battery (also referred to as a diagnostic apparatus or device) according to an embodiment of the present disclosure.

Referring to FIG. 1, the apparatus 100 for diagnosing a battery may include a profile obtaining unit 110, a profile adjusting unit 120, and a control unit 130.

Here, the battery refers to one or more independent battery cells. The battery may have a negative terminal and a positive terminal. More specifically, each of the battery cells may be a physically separable unit. Each of the battery cells may have a negative terminal and a positive terminal. The negative terminals and positive terminals of the battery cells may be connected in series or in parallel to provide a negative terminal and positive terminal of the battery. A battery may be for example a lithium-ion battery or a lithium polymer battery. In addition, the battery may be of any type, such as for example a cylindrical battery type, a prismatic battery type or a pouch battery type. Additionally, the battery may also be a battery bank, a battery module or a battery pack in which a plurality of battery cells are connected in series and/or parallel. In the following description and for exemplary purposes only, the battery comprises an independent battery cell.

The profile obtaining unit 110 may be configured to obtain or receive a battery profile M representing a correspondence relationship between voltage and capacity of the battery.

The battery profile M may be, for example, a data structure that interrelates respective measurement values of the capacity Q of a battery to corresponding measurement values of the voltage V of the battery for the respective measurement values of the capacity Q (or vice versa). The battery profile M may be determined in in a charging and/or discharging process of the battery. The battery profile M may for example be or may be represented in a two-dimensional data array. In some embodiments, the battery profile M may be representable as a two-dimensional profile, where one axis of the profile (e.g. the x-axis) denotes measurement values of the capacity Q of a battery, and another axis of the profile (e.g. the y-axis) denotes measurement values of the voltage V of the battery that correspond to the respective measurement values of the capacity Q of the battery. The number of pairs of measurement values of the capacity Q and corresponding measurement values of the voltage V in the battery profile M may be determined by the number of measurements. Optionally, it is also possible to interpolate intermediate pairs of values of the capacity Q and corresponding values of the voltage V in the battery profile M from the measured pairs of measurement values of the capacity Q and the corresponding voltage V in the battery profile M.

Individual pairs of measurement values of the of the capacity Q and the corresponding voltage V of the battery may be obtained in a charging and/or discharging process of the battery. The individual pairs of measurement values of the of the capacity Q and corresponding measurement values of the of the voltage V of the battery may be obtained in a charging and/or discharging process of the battery in intervals, such as, for example, predetermined or configurable time intervals, predetermined or configurable changes of the capacity Q or predetermined or configurable changes of the state of charge (SOC) of the battery or state of health (SOH) of the battery. The measured voltage V may be a terminal voltage of the battery. The terminal voltage may be measured across the battery terminals while it is powering a load/discharging or during charging. In this case, the interval between measurements of a pair of capacity values Q and voltage values V may be a predetermined or configurable fixed interval. Alternatively, the measured voltage V may be an open circuit voltage (OCV). The OCV of the battery may be measured when no load is applied (i.e., the battery is at rest and not charging or discharging). In this case, the interval between measuring individual pairs of capacity Q and voltage V may be determined, for example, every time the battery is at rest for a predetermined amount of time (and not charging or discharging) so that transient effects on the measurements can be avoided or reduced. As noted above, if necessary, intermediate pairs of values of the capacity Q and corresponding values of the voltage V in the battery profile M may be interpolated from the measured pairs of measurement values of the capacity Q and the corresponding voltage V in the battery profile M so that the battery profile M provides respective a respective pair of values of the capacity Q and voltage V at some predetermined or configurable "resolution" (e.g. in intervals of the capacity, e.g. a pair of values for every step (e.g. 1%, 2%, 3%, or 5%) of the capacity Q).

For example, the battery profile M is a profile representing the correspondence relationship between voltage V and capacity Q when the SOC of the battery is charged from a preset charge start SOC (e.g. 0%, 5%, 10%, 15% or 20%) to a preset charge end SOC (e.g. 45%, 50%, 55%, 60%, 70%, 80%, 90% or 100%). As another example, the battery profile M may represent the correspondence relationship between voltage V and capacity Q when the state of charge of the battery is discharged from the preset discharge start SOC (e.g. 45%, 50%, 55%, 60%, 70%, 80%, 90% or 100%) to the preset discharge end SOC (e.g. 0%, 5%, 10%, 15% or 20%). The SoC may represent the remaining capacity of the battery as a percentage of its total charge capacity. Essentially, the SoC may thus indicate how "full" the battery is at a given moment. In another example, the battery profile M is a profile representing the correspondence relationship between voltage V and capacity Q when the SOH of the battery is charged from a preset charge start SOC (e.g. 0%, 5%, 10%, 15% or 20%) to a preset charge end SOH (e.g. 45%, 50%, 55%, 60%, 70%, 80%, 90% or 100%). In yet another example, the battery profile M may represent the correspondence relationship between voltage V and capacity Q when the state of charge of the battery is discharged from the preset discharge start SOH (e.g. 45%, 50%, 55%, 60%, 70%, 80%, 90% or 100%) to the preset discharge end SOH (e.g. 0%, 5%, 10%, 15% or 20%). The SoH may represent the overall health or condition of a battery relative to its original, initial state (e.g. BOL (Beginning of Life) state). The SoH may thus reflect the battery's aging and degradation over time.

For example, when obtaining the battery profile M while charging or discharging the battery, there is no special limitation on the C-rate in charging or discharging for generating the battery profile M. However, preferably, the battery should be charged or discharged at a low rate in order to obtain a more accurate battery profile M. For example, the battery profile M may be generated in the process of charging or discharging the battery at 0.05 C.

In some embodiments, the profile obtaining unit 110 may obtain/receive the battery profile M from the outside. That is, the profile obtaining unit 110 may obtain/receive the battery profile M from an external device or unit. The external device or unit may be connected to the profile obtaining unit 110 via wire and/or wirelessly for receiving the battery profile M. The external device or unit may be comprised by the apparatus 100 for diagnosing a battery or may be an external entity.

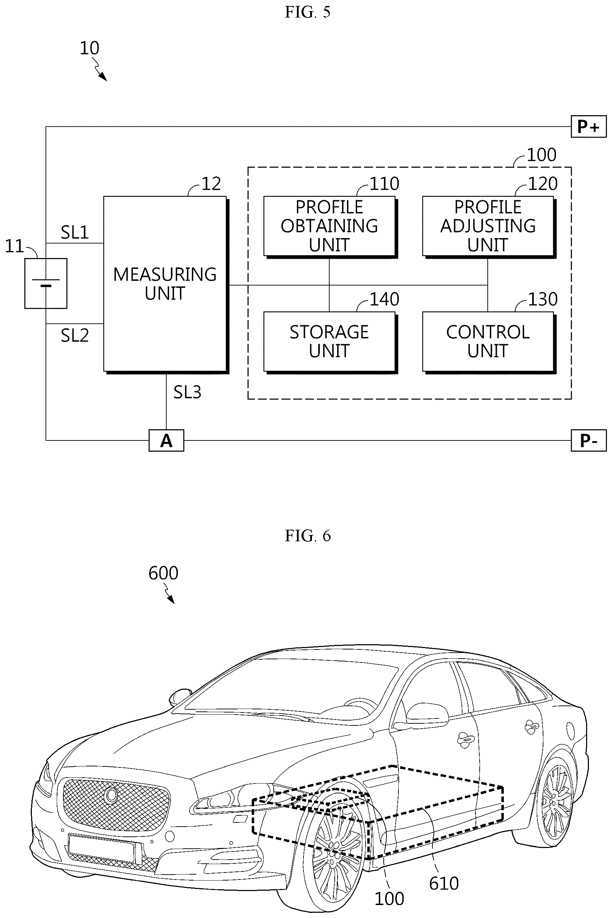

In some other embodiments, the profile obtaining unit 110 may be configured to generate the battery profile M. For this, the profile obtaining unit 110 may receive the battery information about the voltage and capacity of the battery. In some embodiments, the profile obtaining unit 110 may be configured to control a measurement unit (for example, measuring unit 12, see FIG. 5). The measurement unit may be configured to measure pairs of measurement values of the capacity Q and the voltage V of the battery, and may provide the pairs of measurement values of the capacity Q and the voltage V of the battery as battery information to the profile obtaining unit 110 for generating the battery profile M. Then, the profile obtaining unit 110 may generate a battery profile M based on the received battery information. That is, the profile obtaining unit 110 may obtain the battery profile M by directly generating the battery profile M based on the battery information.

The measurement unit may be comprised by the apparatus 100 for diagnosing a battery or may be an external entity. Further, in implementations, where the profile obtaining unit 110 obtains/receives the battery profile M from the outside from an external device or unit, the external device or unit may comprise the measurement unit.

The profile obtaining unit 110 may be connected to communicate with the control unit 130. For example, the profile obtaining unit 110 may be connected to the control unit 130 by wire and/or wirelessly. The profile obtaining unit 110 may transmit the obtained battery profile M to the control unit 130.

The profile adjusting unit 120 may be configured to adjust a preset reference positive electrode profile Rp and a reference negative electrode profile Rn to correspond to the battery profile M, thereby generating an adjusted positive electrode profile Rp' and an adjusted negative electrode profile Rn'.

Here, the reference positive electrode profile Rp may be a profile representing a correspondence relationship between the capacity and voltage of a preset reference positive electrode cell to correspond to the positive electrode of the battery. For example, the reference positive electrode cell may be a positive electrode coin half-cell or a positive electrode of a three-electrode cell. As a specific example, the reference positive electrode profile Rp may be preset to correspond to the positive electrode of the battery in the BOL (Beginning of Life) state. That is, the reference positive electrode profile Rp may be estimated as the positive electrode profile of the battery in the BOL state. Similar to the battery profile M, the reference positive electrode profile Rp may be a data structure that interrelates respective values of the capacity Q of preset reference positive electrode cell to corresponding values of the voltage V of the preset reference positive electrode cell for the respective values of the capacity Q (or vice versa). The reference positive electrode profile Rp may for example be or may be represented in a two-dimensional data array. In some embodiments, the capacity/voltage pairs in the reference negative electrode profile Rn are provided at the same resolution (e.g. 1%, 2%, 3%, or 5% of the capacity Q, but also finer resolutions may be employed) as the resolution of capacity/voltage pairs in the battery profile M.

In addition, the reference negative electrode profile Rn may be a profile representing a correspondence relationship between the capacity and voltage of a preset reference negative electrode cell to correspond to the negative electrode of the battery. For example, the reference negative electrode cell may be a negative electrode coin half-cell or a negative electrode of a 3-electrode cell. As a specific example, the reference negative electrode profile Rn may be preset to correspond to the negative electrode of the battery in the BOL state. That is, the reference negative electrode profile Rn may be estimated as the negative electrode profile of the battery in the BOL state. Similar to the reference positive electrode profile Rp, the reference negative electrode profile Rn may be a data structure that interrelates respective values of the capacity Q of preset reference negative electrode cell to corresponding values of the voltage V of the preset reference negative electrode cell for the respective values of the capacity Q (or vice versa). The reference negative electrode profile Rn may for example be or may be represented in a two-dimensional data array. In some embodiments, the capacity/voltage pairs in the reference negative electrode profile Rn are provided at the same resolution (e.g. 1%, 2%, 3%, or 5% of the capacity Q, but also finer resolutions may be employed) as the resolution of capacity/voltage pairs in the reference positive electrode profile Rp. In addition or alternatively, the capacity/voltage pairs in the reference negative electrode profile Rn are provided at the same resolution (e.g. 1%, 2%, 3%, or 5% of the capacity Q, but also finer resolutions may be employed) as the resolution of capacity/voltage pairs in the battery profile M.

The reference positive electrode cell and the reference negative electrode cell may be used as benchmarks to assess and diagnose the state of a battery by comparing their profiles Rp and Rn with the battery profile M of the battery under evaluation. The reference positive electrode cell may, in some embodiments, represent a preset model representing the capacity and voltage relationship of a positive electrode in a standardized and/or idealized state (e.g., at BOL). Likewise, the reference negative electrode cell may, in some embodiments, represent the standardized relationship between capacity and voltage for the negative electrode in the standardized and/or idealized state (e.g., at BOL). The profiles Rp and Rn of these reference cells may be adjusted to align with the measured battery profile M to create adjusted profiles Rp' and Rn' (for both positive and negative electrodes). These adjusted profiles Rp' and Rn' may be used to identify deviations caused by degradation, such as lithium loss, capacity fade, or electrode wear.

Specifically, the profile adjusting unit 120 may adjust the reference positive electrode profile Rp and the reference negative electrode profile Rn to correspond to the battery profile M. More specifically, the profile adjusting unit 120 may generate an adjusted positive electrode profile Rp' and an adjusted negative electrode profile Rn' by adjusting the reference positive electrode profile Rp and the reference negative electrode profile Rn. The profile adjusting unit 120 may for example adjust the reference positive electrode profile Rp and the reference negative electrode profile Rn to match the battery profile M by using an iterative process.

In some embodiments, the profile adjusting unit 120 may generate a comparison profile from the adjusted positive electrode profile Rp' and the adjusted negative electrode profile Rn'. The profile adjusting unit 120 may adjust the reference positive electrode profile Rp and the reference negative electrode profile Rn until the comparison profile corresponds to the battery profile M. For example, the profile adjusting unit 120 may generate a plurality of comparison profiles by shifting or capacity-scaling the reference positive electrode profile Rp and the reference negative electrode profile Rn, and may specify a comparison profile having a minimum error with the battery profile M among the plurality of comparison profiles. Then, the profile adjusting unit 120 may determine an adjusted positive electrode profile Rp' corresponding to the specified comparison profile as the positive electrode profile of the battery. Then, the profile adjusting unit 120 may determine an adjusted negative electrode profile Rn' corresponding to the specified comparison profile as the negative electrode profile of the battery. That is, the adjusted positive electrode profile Rp' and the adjusted negative electrode profile Rn' corresponding to the specified comparison profile may be estimated as the positive electrode profile and the negative electrode profile of the battery, respectively.

FIG. 2 is a drawing schematically showing an adjustment result of a reference positive electrode profile Rp and a reference negative electrode profile Rn according to an embodiment of the present disclosure.

Specifically, in the embodiment of FIG. 2, the profile adjusting unit 120 may generate an adjusted positive electrode profile Rp' and an adjusted negative electrode profile Rn' by adjusting the reference positive electrode profile Rp and the reference negative electrode profile Rn. That is, the adjusted positive electrode profile Rp' and the adjusted negative electrode profile Rn' are generated according to the organic relationship between the reference positive electrode profile Rp and the reference negative electrode profile Rn.

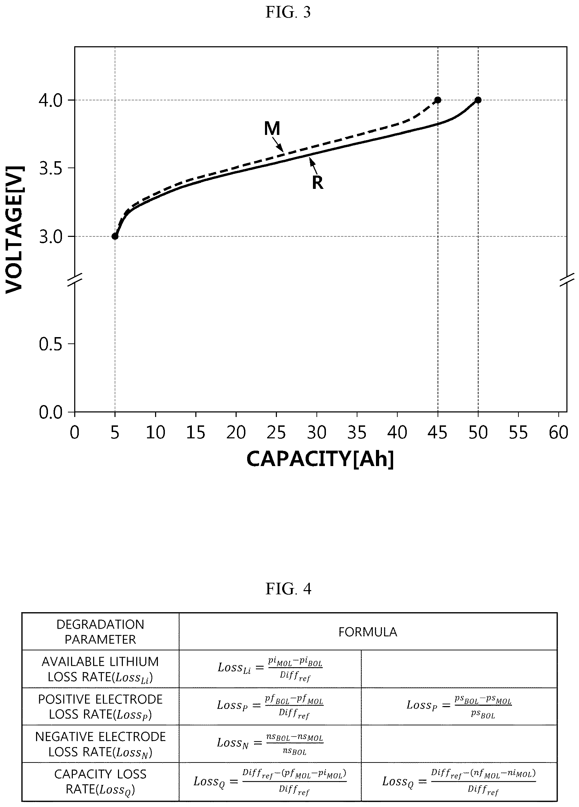

The profile adjusting unit 120 may thus modify the reference positive electrode profile Rp and the reference negative electrode profile Rn to align them with the measured battery profile M. This process may involve generating multiple comparison profiles by shifting or scaling the capacity of the reference profiles Rp and Rn. These comparison profiles may be evaluated against the battery profile M (e.g. using a full-cell profile R that is compared to the battery profile M as explained below in connection with Fig. 3), with the goal of minimizing the error or difference between them. The comparison profile among the comparison profile that produces the smallest error may be identified as the best match, and the reference profiles Rn and Rp are adjusted accordingly using this best-matching comparison profile to produce the adjusted positive electrode profile Rp' and the adjusted negative electrode profile Rn'.

In some embodiments, the adjustment may be implemented in an iterative process that refines the profiles Rp and Rn until the adjusted profiles Rp' and Rn' (or the full-cell profile R that is based on the adjusted profiles Rp' and Rn') closely reflect the actual behavior of the battery within an acceptable margin of error. These adjustments of the reference profiles Rp and Rn may be implemented, for example, because the reference profiles Rp and Rn are based on the ideal or BOL state of the battery, which does not account for changes caused by degradation over time. As the battery ages, factors such as lithium loss, capacity fade, and electrode wear alter its performance. By aligning the reference profiles Rp and Rn with the current battery profile M, the adjusted profiles Rp' and Rn' provide a more accurate representation of the battery's current state, enabling a more precise diagnostics of degradation parameters and an evaluation of the battery's health as outlined in more detail below.

FIG. 3 is a drawing schematically showing a battery profile M and a reference full-cell profile R according to an embodiment of the present disclosure. The reference full-cell profile R may be considered representing the overall voltage-capacity relationship of a complete battery cell under standardized and/or idealized, reference conditions (e.g., at BOL). The reference full-cell profile R may be derived by combining the reference positive electrode profile Rp and the reference negative electrode profile Rn.

In the embodiment of FIG. 3, the reference full-cell profile R may be a profile based on the reference positive electrode profile Rp and the reference negative electrode profile Rn. Specifically, the voltage difference by capacity for the reference positive electrode profile Rp and the reference negative electrode profile Rn may be expressed as the reference full-cell profile R. The reference full-cell profile R may thus represent the voltage difference between Rp and Rn as a function of capacity.

Since the reference full-cell profile R may be significantly different from the battery profile M, the profile adjusting unit 120 may generate a plurality of comparison profiles corresponding to the battery profile M by adjusting the reference positive electrode profile Rp and the reference negative electrode profile Rn, as noted above. The profile adjusting unit 120 may specify a comparison profile having the smallest error with the battery profile M among the plurality of comparison profiles. The comparison profile specified by the profile adjusting unit 120 may thus be the comparison profile among the comparison profiles that provides the adjusted positive electrode profile Rp' and adjusted negative electrode profile Rn', which together form a full-cell profile R that best matches the measured battery profile M. In addition, the adjusted positive electrode profile Rp' and the adjusted negative electrode profile Rn' based on the specified comparison profile may be set as or defined/treated as the (new) positive electrode profile Rp and the (new) negative electrode profile Rn of the battery. This step of redefining the positive and negative electrode profiles Rp and Rn may be employed to reflect the battery's real-world behavior at its current state of health.

The control unit 130 may be configured to extract a diagnostic factor for the battery from at least one of the adjusted positive electrode profile Rp' and the adjusted negative electrode profile Rn'. The diagnostic factor may also be referred to as a diagnostic parameter for the battery.

Specifically, the adjusted positive electrode profile Rp' includes a first feature point corresponding to a positive electrode participation start point (hereinafter referred to as pi') and a second feature point corresponding to a positive electrode participation end point (hereinafter referred to as pf). Here, the positive electrode participation start point (pi') means a positive electrode point where a reaction starts during a charging process or a positive electrode point where a reaction ends during a discharging process. The positive electrode participation end point (pf') means a positive electrode point where a reaction ends during a charging process or a positive electrode point where a reaction starts during a discharging process. The positive electrode participation start point (pi') may refer to a charge value Qpi [Ah], and corresponding voltage value Vpi [V], as for example indicated in FIG. 2. The positive electrode participation end point (pf') may refer to a charge value Qpf [Ah], and corresponding voltage value Vpf [V], as for example indicated in FIG. 2. The positive electrode participation start point and positive electrode participation end point may thus describe the points at which the positive electrode begins or ceases to actively participate in electrochemical reactions during the battery's charge or discharge cycle.

Similarly, the adjusted negative electrode profile Rn' includes a third feature point corresponding to a negative electrode participation start point (hereinafter referred to as ni') and a fourth feature point corresponding to a negative electrode participation end point (hereinafter referred to as nf'). Here, the negative electrode participation start point (ni') means a negative electrode point where a reaction starts during the charging process or a negative electrode point where a reaction ends during the discharging process. The negative electrode participation end point (nf') means a negative electrode point where a reaction ends during the charging process or a negative electrode point where a reaction starts during the discharging process. The negative electrode participation start point (ni') may refer to a charge value Qni [Ah], and corresponding voltage value Vni [V], as for example indicated in FIG. 2. The negative electrode participation end point (nf') may refer to a charge value Qnf [Ah], and corresponding voltage value Vnf [V], as for example indicated in FIG. 2. The negative electrode participation start point and negative electrode participation end point may thus describe the points at which the negative electrode begins or ceases to actively participate in electrochemical reactions during the battery's charge or discharge cycle.

In the embodiment of FIG. 2, the adjustment positive electrode profile Rp' may thus include a first feature point (pi') and a second feature point (pf'). The adjustment negative electrode profile Rn' may thus include the third feature point (ni') and the fourth feature point (nf').

The first feature value (pi_{MOL}) of the adjusted positive electrode profile Rp' is a value representing at least one of the capacity, voltage, or SOC of the first feature point (pi'). Preferably, the first feature value (pi_{MOL}) is the SOC of the first feature point (pi').

For example, the first feature value (pi_{MOL}) may be calculated as the SOC of the first feature point (pi') with respect to the capacity of the adjusted positive electrode profile Rp'. Assume that the entire capacity section of the adjusted positive electrode profile Rp' is Qi [Ah] to Qf [Ah], and assume that the capacity of the first feature point (pi') is Qpi [Ah]. The first feature value (pi_{MOL}) may be calculated according to the formula "(Qpi - Qi) ÷ (Qf - Qi) × 100".

As another example, the first feature value (pi_{MOL}) may also be calculated as the SOC of the first feature point (pi') with respect to the capacity of the adjusted negative electrode profile Rn'. In this case, assume the entire capacity section of the adjusted negative electrode profile Rn' is Qi [Ah] to Qf [Ah], and assume that the capacity of the first feature point (pi') is Qpi [Ah]. The first feature value (pi_{MOL}) may be calculated according to the formula "(Qpi - Qi) ÷ (Qf - Qi) × 100".

As still another example, the first feature value (pi_{MOL}) may also be calculated as the SOC of the first feature point (pi') for the capacity of the battery profile M. In this case, assume the entire capacity section of the battery profile M is Qi [Ah] to Qf [Ah], and assume that the capacity of the first feature point (pi') is Qpi [Ah]. The first feature value (pi_{MOL}) may be calculated according to the formula "(Qpi - Qi) ÷ (Qf - Qi) × 100".

The second feature value (pf_{MOL}) of the adjusted positive electrode profile Rp' is a value representing at least one of the capacity, voltage, or SOC of the second feature point (pf'). Preferably, the second feature value (pf_{MOL}) is the SOC of the second feature point (pf').

For example, the second feature value (pf_{MOL}) may be calculated as the SOC of the second feature point (pf') with respect to the capacity of the adjusted positive electrode profile Rp'. Assume that the entire capacity range of the adjusted positive electrode profile Rp' is Qi [Ah] to Qf [Ah], and assume that the capacity of the second feature point (pf') is Qpf [Ah]. The second feature value (pf_{MOL}) may be calculated according to the formula "(*Qpf* - *Qi*) ÷ (*Qf* - *Qi*) × 100".

As another example, the second feature value (pf_{MOL}) may also be calculated as the SOC of the second feature point (pf') with respect to the capacity of the adjusted negative electrode profile Rn'. In this case, assume that the entire capacity range of the adjusted negative electrode profile Rn' is Qi [Ah] to Qf [Ah], and assume that the capacity of the second feature point (pf') is Qpf [Ah]. The second feature value (pf_{MOL}) may be calculated according to the formula "(*Qpf* - *Qi*) ÷ (*Qf* - *Qi*) × 100".

As another example, the second feature value (pf_{MOL}) may also be calculated as the SOC of the second feature point (pf') for the capacity of the battery profile M. In this case, assume that the entire capacity range of the battery profile M is Qi [Ah] to Qf [Ah], and assume that the capacity of the second feature point (pf') is Qpf [Ah]. The second feature value (pf_{MOL}) may be calculated according to the formula "(*Qpf* - *Qi*) ÷ (*Qf* - *Qi*) × 100".

The third feature value (ni_{MOL}) of the adjusted negative electrode profile Rn' is a value representing at least one of the capacity, voltage, or SOC of the third feature point (ni'). Preferably, the third feature value (ni_{MOL}) is the SOC of the third feature point (ni').

For example, the third feature value (ni_{MOL}) may be calculated as the SOC of the third feature point (ni') with respect to the capacity of the adjusted negative electrode profile Rn'. Assume that the entire capacity range of the adjusted negative electrode profile Rn' is Qi [Ah] to Qf [Ah], and the capacity of the third feature point (ni') is Qni [Ah]. The third feature value (ni_{MOL}) may be calculated according to the formula "(*Qni* - *Qi)* ÷ (*Qf - Qi*) × 100".

As another example, the third feature value (ni_{MOL}) may also be calculated as the SOC of the third feature point (ni') with respect to the capacity of the adjusted positive electrode profile Rp'. In this case, assume that the entire capacity range of the adjusted positive electrode profile Rp' is Qi [Ah] to Qf [Ah], and the capacity of the third feature point (ni') is Qni [Ah]. The third feature value (ni_{MOL}) may be calculated according to the formula "(*Qni* - *Qi)* - (*Qf* - *Qi*) × 100".

As still another example, the third feature value (ni_{MOL}) may also be calculated as the SOC of the third feature point (ni') with respect to the capacity of the battery profile M. In this case, assume that the entire capacity range of the battery profile M is Qi [Ah] to Qf [Ah], and the capacity of the third feature point (ni') is Qni [Ah]. The third feature value (ni_{MOL}) may be calculated according to the formula "(*Qni* - *Qi*) ÷ (*Qf* - *Qi*) × 100".

The fourth feature value (nf_{MOL}) of the adjusted negative electrode profile Rn' is a value representing at least one of the capacity, voltage, or SOC of the fourth feature point (nf'). Preferably, the fourth feature value (nf_{MOL}) is the SOC of the fourth feature point (nf').

For example, the fourth feature value (nf_{MOL}) may be calculated as the SOC of the fourth feature point (nf') with respect to the capacity of the adjusted negative electrode profile Rn'. Assume that the entire capacity range of the adjusted negative electrode profile Rn' is Qi [Ah] to Qf [Ah], and the capacity of the fourth feature point (nf') is Qnf [Ah]. The fourth feature value (nf_{MOL}) may be calculated according to the formula "(*Qnf* - *Qi*) ÷ (*Qf - Qi*) × 100".

As another example, the fourth feature value (nf_{MOL}) may also be calculated as the SOC of the fourth feature point (nf') with respect to the capacity of the adjusted positive electrode profile Rp'. In this case, assume that the entire capacity range of the adjusted positive electrode profile Rp' is Qi [Ah] to Qf [Ah], and the capacity of the fourth feature point (nf') is Qnf [Ah]. The fourth feature value (nf_{MOL}) may be calculated according to the formula *"*(*Qnf* - *Qi*) ÷ (*Qf* - *Qi*) × 100".

As still another example, the fourth feature value (nf_{MOL}) may also be calculated as the SOC of the fourth feature point (nf') with respect to the capacity of the battery profile M. In this case, assume that the entire capacity range of the battery profile M is Qi [Ah] to Qf [Ah], and the capacity of the fourth feature point (nf') is Qnf [Ah]. The fourth feature value (nf_{MOL}) may be calculated according to the formula *"*(*Qnf* - *Qi*) ÷ (*Qf* - *Qi*) × 100".

The positive electrode change rate (ps_{MOL}) of the adjusted positive electrode profile Rp' is a value representing a rate of change of the adjusted positive electrode profile Rp' with respect to the reference positive electrode profile Rp. That is, the positive electrode change rate (ps_{MOL}) is a scale factor of the adjusted positive electrode profile Rp' with respect to the reference positive electrode profile Rp. For example, the positive electrode change rate (ps_{MOL}) may represent a ratio of the capacity difference between two points (pi', pf') of the adjusted positive electrode profile Rp' with respect to the capacity difference between two points (pi0, pf0) of the reference positive electrode profile Rp. Here, pi0 corresponds to the positive electrode participation start point of the reference positive electrode profile Rp, and pf0 corresponds to the positive electrode participation end point of the reference positive electrode profile Rp. Similar to the points (pi', pf') of the adjusted positive electrode profile Rp', the positive electrode participation start point pi0 and positive electrode participation end point pf0 in the reference positive electrode profile Rp may describe the points at which the positive electrode begins or ceases to actively participate in electrochemical reactions during the battery's charge or discharge cycle.

The negative electrode change rate (ns_{MOL}) of the adjusted negative electrode profile Rn' is a value representing a rate of change of the adjusted negative electrode profile Rn' with respect to the reference negative electrode profile Rn. That is, the negative electrode change rate (ns_{MOL}) is a scale factor of the adjusted negative electrode profile Rn' with respect to the reference negative electrode profile Rn. For example, the negative electrode change rate (ns_{MOL}) may represent a ratio of the capacity difference between two points (ni', nf') of the adjusted negative electrode profile Rn' with respect to the capacity difference between two points (ni0, nf0) of the reference negative electrode profile Rn. Here, ni0 corresponds to the negative electrode participation start point of the reference negative electrode profile Rn, and nf0 corresponds to the negative electrode participation end point of the reference negative electrode profile Rn. Similar to the points (ni', nf') of the adjusted negative electrode profile Rn', the negative electrode participation start point ni0 and negative electrode participation end point nf0 in the reference negative electrode profile Rn may describe the points at which the negative electrode begins or ceases to actively participate in electrochemical reactions during the battery's charge or discharge cycle.

Specifically, the control unit 130 may extract at least one of the first feature value (pi_{MOL}), the second feature value (pf_{MOL}), the third feature value (ni_{MOL}), the fourth feature value (nf_{MOL}), the positive electrode change rate (ps_{MOL}), and the negative electrode change rate (ns_{MOL}) as a diagnostic factor.

The control unit 130 may be configured to diagnose the state of the battery based on the extracted diagnostic factor.

Specifically, the control unit 130 may calculate a degradation parameter for diagnosing the state of the battery based on the diagnostic factor extracted from the adjusted positive electrode profile Rp' and/or the adjusted negative electrode profile Rn'.

For example, the control unit 130 may be configured to output a degradation parameter including at least one of an available lithium loss rate (Loss_{Li}), a positive electrode loss rate (Loss_{P}), a negative electrode loss rate (Loss_{N}), and a capacity loss rate (Loss_{Q}) based on the extracted diagnostic factor.

Here, the available lithium loss rate (Loss_{Li}) refers to the rate at which the available lithium of the battery is lost. That is, the available lithium loss rate (Loss_{Li}) refers to the degree to which lithium that may be used for charge and discharge is lost. Specifically, the available lithium loss rate (Loss_{Li}) may represent how much the available lithium amount of the battery in the current state is lost based on the available lithium amount of the battery in the BOL state. For example, if the available lithium loss rate (Loss_{Li}) is 1%, it means that the available lithium amount of the battery in the current state is lost by 1% compared to the available lithium amount of the battery in the BOL state. In other words, if the available lithium loss rate (Loss_{Li}) is 1%, the available lithium SOH (State of Health) of the battery in the current state is 99%. For example, the available lithium loss rate (Loss_{Li}) may be calculated based on the first feature value (pi_{MOL}).

Next, the positive electrode loss rate (Loss_{P}) refers to the rate at which the positive electrode of the battery is lost. That is, the positive electrode loss rate (Loss_{P}) may represent how much the positive electrode capacity of the battery in the current state is lost based on the positive electrode capacity of the battery in the BOL state. For example, if the positive electrode loss rate (Loss_{P}) is 1%, it means that the positive electrode capacity of the battery in the current state is lost by 1% compared to the positive electrode capacity of the battery in the BOL state. In other words, if the positive electrode loss rate (Loss_{P}) is 1%, the positive electrode SOH of the battery in the current state is 99%. For example, the positive electrode loss rate (Loss_{P}) may be calculated based on the second feature value (pf_{MOL}) or the positive electrode change rate (pf_{MOL}).

Next, the negative electrode loss rate (Loss_{N}) refers to the rate at which the negative electrode of the battery is lost. That is, the negative electrode loss rate (Loss_{N}) may represent how much the negative electrode capacity of the battery in the current state is lost based on the negative electrode capacity of the battery in the BOL state. For example, if the negative electrode loss rate (Loss_{N}) is 1%, it means that the negative electrode capacity of the battery in the current state is lost by 1% compared to the negative electrode capacity of the battery in the BOL state. In other words, if the negative electrode loss rate (Loss_{N}) is 1%, the negative electrode SOH of the battery in the current state is 99%. For example, the negative electrode loss rate (Loss_{N}) may be calculated based on the negative electrode change rate (ns_{MOL}).

Finally, the capacity loss rate (Loss_{Q}) represents the rate at which the capacity of the battery is lost. That is, the capacity loss rate (Loss_{Q}) may represent how much the capacity of the battery in the current state is lost based on the capacity of the battery in the BOL state. For example, if the capacity loss rate (Loss_{Q}) is 1%, it means that the capacity of the battery in the current state is lost by 1% compared to the capacity of the battery in the BOL state. In other words, if the capacity loss rate (Loss_{Q}) is 1%, the capacity SOH of the battery in the current state is 99%. For example, the capacity loss rate (Loss_{Q}) may be calculated based on the first feature value (pi_{MOL}) and the second feature value (pf_{MOL}). As another example, the capacity loss rate (Loss_{Q}) may be calculated based on the third feature value (ni_{MOL}) and the fourth feature value (nf_{MOL}).

FIG. 4 is a drawing schematically showing a degradation parameter according to an embodiment of the present disclosure. Specifically, FIG. 4 is a diagram that organizes formulas for the available lithium loss rate (Loss_{Li}), the positive electrode loss rate (Loss_{P}), the negative electrode loss rate (Loss_{N}), and the capacity loss rate (Loss_{Q}). A specific example in which the control unit 130 calculates degradation parameters using the formulas of FIG. 4 will be described later.

In addition or alternatively, the control unit 130 may be configured to diagnose the state of the battery based on the calculated degradation parameter.

Specifically, the control unit 130 may diagnose the state of the battery corresponding to the calculated degradation parameter. That is, the state of the battery that may be calculated for each degradation parameter may be set in advance.

For example, the state of the battery that the control unit 130 may diagnose may be an available lithium loss state, a positive electrode loss state, a negative electrode loss state, a capacity loss state, or a normal state.

Specifically, the control unit 130 may diagnose whether the state of the battery is an available lithium loss state based on the available lithium loss rate (Loss_{Li}). Further, the control unit 130 may diagnose whether the state of the battery is a positive electrode loss state based on the positive electrode loss rate (Loss_{P}). Further, the control unit 130 may diagnose whether the state of the battery is a negative electrode loss state based on the negative electrode loss rate (Loss_{N}). Further, the control unit 130 may diagnose whether the state of the battery is a capacity loss state based on the capacity loss rate (Loss_{Q}). Finally, if the state of the battery is not the available lithium loss state, the positive electrode loss state, the negative electrode loss state, and the capacity loss state, the control unit 130 may diagnose the state of the battery as a normal state.

Preferably, a threshold value may be set for each degradation parameter. Here, the threshold value is a preset value for distinguishing between a normal state and an abnormal state. For example, values equal to or less than the threshold value may be said to belong to a normal state, and values exceeding the threshold value may be said to belong to an abnormal state. The control unit 130 may compare the degradation parameter with the corresponding threshold value and diagnose the state of the battery based on the comparison result.

The apparatus 100 for diagnosing a battery according to an embodiment of the present disclosure may non-destructively estimate a positive electrode profile and a negative electrode profile of a battery, and specifically distinguish and diagnose the state of the battery based on the estimated positive electrode profile and negative electrode profile. That is, according to the apparatus 100 for diagnosing a battery, the positive/negative electrode profiles reflecting the current state of the battery are generated, and the state of the battery may also be diagnosed very specifically.

Meanwhile, the profile obtaining unit 110, the profile adjusting unit 120 and the control unit 130 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110, the profile adjusting unit 120 and the control unit 130 may be implemented as a set of program modules. At this time, the program module may be stored in the memory and executed by the profile obtaining unit 110, the profile adjusting unit 120 and the control unit 130. The memory may be inside or outside the profile obtaining unit 110, the profile adjusting unit 120 and the control unit 130 and may be connected to the profile obtaining unit 110, the profile adjusting unit 120 and the control unit 130 by various well-known means.

In addition, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the profile obtaining unit 110, the profile adjusting unit 120 and the control unit 130 are defined.

For example, the storage unit 140 may store data used for diagnosing the state of a battery, such as the battery profile M, the reference positive electrode profile Rp, the reference negative electrode profile Rn, the adjusted positive electrode profile Rp', the adjusted negative electrode profile Rn', the comparison profile, and the degradation parameters.

Below, each parameter included in the embodiment of FIG. 4 will be described.
(1) Loss_{Li} means the available lithium loss rate.
(2) Loss_{P} means the positive electrode loss rate.
(3) Loss_{N} means the negative electrode loss rate.
(4) Loss_{Q} means the capacity loss rate.
(5) pi_{BOL} refers to the first reference feature value for the first reference feature point (pi0) of the reference positive electrode profile Rp. For example, pi_{BOL} may be the SOC of the first reference feature point (pi0). That is, the first reference feature value (pi_{BOL}) is the feature value for the positive electrode participation start point of the reference positive electrode profile Rp.

For example, the first reference feature value (pi_{BOL}) may be calculated as the SOC of the first reference feature point (pi0) with respect to the capacity of the reference positive electrode profile Rp. Assume that the entire capacity section of the reference positive electrode profile Rp is Qi0 [Ah] to Qf0 [Ah], and the capacity of the first reference feature point (pi0) is QpiO [Ah]. The first reference feature value (pi_{BOL}) may be calculated according to the formula of *"*(*Qpi*0 - *Qi*0) ÷ (*Qf*0 - *Qi*0) × 100".

As another example, the first reference feature value (pi_{BOL}) may be calculated as the SOC of the first reference feature point (pi0) with respect to the capacity of the reference negative electrode profile Rn. Assume that the entire capacity section of the reference negative electrode profile Rn is Qi0 [Ah] to Qf0 [Ah], and the capacity of the first reference feature point (pi0) is QpiO [Ah]. The first reference feature value (pi_{BOL}) may be calculated according to the formula of "(*Qpi*0 - *Qi*0) ÷ (*Qf*0 - *Qi*0) × 100".

As still another example, the first reference feature value (pi_{BOL}) may be calculated as the SOC of the first reference feature point (pi0) with respect to the capacity of the reference full-cell profile R. Assume that the entire capacity section of the reference full-cell profile R is Qi0 [Ah] to Qf0 [Ah], and the capacity of the first reference feature point (pi0) is QpiO [Ah]. The first reference feature value (pi_{BOL}) may be calculated according to the formula of "(*Qpi*0 - *Qi*0) ÷ (*Qf*0 - *Qi*0) × 100".

(6) pf_{BOL} refers to the second reference feature value for the second reference feature point (pf0) of the reference positive electrode profile Rp. For example, pf_{BOL} may be the SOC of the second reference feature point (pf0). That is, the second reference feature value (pf_{BOL}) is a feature value for the positive electrode participation end point of the reference positive electrode profile Rp.

For example, the second reference feature value (pf_{BOL}) may be calculated as the SOC of the second reference feature point (pf0) with respect to the capacity of the reference positive electrode profile Rp. Assume that the entire capacity section of the reference positive electrode profile Rp is Qi0 [Ah] to Qf0 [Ah], and the capacity of the second reference feature point (pf0) is QpfO [Ah]. The second reference feature value (pf_{BOL}) may be calculated according to the formula "(QpfO - Qi0) ÷ (QfU - Qi0) × 100".

As another example, the second reference feature value (pf_{BOL}) may be calculated as the SOC of the second reference feature point (pf0) with respect to the capacity of the reference negative electrode profile Rn. Assume that the entire capacity section of the reference negative electrode profile Rn is Qi0 [Ah] to Qf0 [Ah], and the capacity of the second reference feature point (pf0) is QpfO [Ah]. The second reference feature value (pf_{BOL}) may be calculated according to the formula "(QpfO - Qi0) ÷ (QfU - Qi0) × 100".

As still another example, the second reference feature value (pf_{BOL}) may be calculated as the SOC of the second reference feature point (pf0) with respect to the capacity of the reference full-cell profile R. Assume that the entire capacity section of the reference full-cell profile R is Qi0 [Ah] to QfU [Ah], and the capacity of the second reference feature point (pf0) is QpfO [Ah]. The second reference feature value (pf_{BOL}) may be calculated according to the formula "(QpfO - Qi0) ÷ (Qf0 - Qi0) × 100".

(7) ni_{BOL} refers to the third reference feature value for the third reference feature point (ni0) of the reference negative electrode profile Rn. For example, ni_{BOL} may be the SOC of the third reference feature point (ni0). That is, the third reference feature value (ni_{BOL}) is the feature value for the negative electrode participation start point of the reference negative electrode profile Rn.

For example, the third reference feature value (ni_{BOL}) may be calculated as the SOC of the third reference feature point (ni0) with respect to the capacity of the reference negative electrode profile Rn. Assume that the entire capacity section of the reference negative electrode profile Rn is Qi0 [Ah] to Qf0 [Ah], and the capacity of the third reference feature point (ni0) is QniO [Ah]. The third reference feature value (ni_{BOL}) may be calculated according to the formula of "(QniO - Qi0) ÷ (Qf0 - Qi0) × 100".

As another example, the third reference feature value (ni_{BOL}) may also be calculated as the SOC of the third reference feature point (ni0) with respect to the capacity of the reference positive electrode profile Rp. Assume that the entire capacity section of the reference positive electrode profile Rp is Qi0 [Ah] to Qf0 [Ah], and the capacity of the third reference feature point (ni0) is QniO [Ah]. The third reference feature value (ni_{BOL}) may be calculated according to the formula of "(QniO - Qi0) ÷ (Qf0 - Qi0) × 100".

As still another example, the third reference feature value (ni_{BOL}) may also be calculated as the SOC of the third reference feature point (ni0) with respect to the capacity of the reference full-cell profile R. Assume that the entire capacity section of the reference full-cell profile R is Qi0 [Ah] to QfU [Ah], and the capacity of the third reference feature point (ni0) is QniO [Ah]. The third reference feature value (ni_{BOL}) may be calculated according to the formula of "(QniO - Qi0) ÷ (Qf0 - Qi0) × 100".

(8) nf_{BOL} refers to the fourth reference feature value for the fourth reference feature point (nf0) of the reference negative electrode profile Rn. For example, nf_{BOL} may be the SOC of the fourth reference feature point (nf0). That is, the fourth reference feature value (nf_{BOL}) is a feature value for the negative electrode participation end point of the reference negative electrode profile Rn.

For example, the fourth reference feature value (nf_{BOL}) may be calculated as the SOC of the fourth reference feature point (nf0) with respect to the capacity of the reference negative electrode profile Rn. Assume that the entire capacity section of the reference negative electrode profile Rn is Qi0 [Ah] to Qf0 [Ah], and the capacity of the fourth reference feature point (nf0) is QnfO [Ah]. The fourth reference feature value (nf_{BOL}) may be calculated according to the formula "(Qnf0 - Qi0) ÷ (Qf0) - Qi0) × 100".

As another example, the fourth reference feature value (nf_{BOL}) may also be calculated as the SOC of the fourth reference feature point (nf0) with respect to the capacity of the reference positive electrode profile Rp. Assume that the entire capacity section of the reference positive electrode profile Rp is Qi0 [Ah] to Qf0 [Ah], and the capacity of the fourth reference feature point (nf0) is QnfO [Ah]. The fourth reference feature value (nf_{BOL}) may be calculated according to the formula "(QnfO - Qi0) ÷ (Qf0 - Qi0) × 100".

As still another example, the fourth reference feature value (nf_{BOL}) may also be calculated as the SOC of the fourth reference feature point (nf0) with respect to the capacity of the reference full-cell profile R. Assume that the entire capacity section of the reference full-cell profile R is Qi0 [Ah] to Qf0 [Ah], and the capacity of the fourth reference feature point (nf0) is QnfO [Ah]. The fourth reference feature value (nf_{BOL}) may be calculated according to the formula "(QnfO - Qi0) ÷ (QfU - Qi0) × 100".

(9) ps_{BOL} refers to the reference positive electrode change rate of the reference positive electrode profile Rp. Specifically, ps_{BOL} refers to the change rate of the reference positive electrode profile Rp with respect to the initial positive electrode profile. Here, if the initial positive electrode profile and the reference positive electrode profile Rp are the same, ps_{BOL} may be 1 or 100%. Hereinafter, for the convenience of explanation, it is explained that the initial positive electrode profile and the reference positive electrode profile Rp are the same.

(10) ns_{BOL} refers to the reference negative electrode change rate of the reference negative electrode profile Rn. Specifically, ns_{BOL} refers to the change rate of the reference negative electrode profile Rn with respect to the initial negative electrode profile. Here, if the initial negative electrode profile and the reference negative electrode profile Rn are the same, ns_{BOL} may be 1 or 100%. Hereinafter, for the convenience of explanation, it is explained that the initial negative electrode profile and the reference negative electrode profile Rn are the same.

(11) pi_{MOL} refers to the first feature value for the first feature point (pi') of the adjusted positive electrode profile Rp'. For example, pi_{MOL} may be the SOC of the first feature point (pi').

(12) pf_{MOL} refers to the second feature value for the second feature point (pf') of the adjusted positive electrode profile Rp'. For example, pf_{MOL} may be the SOC of the second feature point (pf').

(13) ni_{MOL} refers to the third feature value for the third feature point (ni') of the adjusted negative electrode profile Rn'. For example, ni_{MOL} may be the SOC of the third feature point (ni').

(14) nf_{MOL} refers to the fourth feature value for the fourth feature point (nf') of the adjusted negative electrode profile Rn'. For example, nf_{MOL} may be the SOC of the fourth feature point (nf').

(15) ps_{MOL} refers to the positive electrode change rate of the adjusted positive electrode profile Rp'. Specifically, ps_{MOL} refers to the change rate of the adjusted positive electrode profile Rp' with respect to the reference positive electrode profile Rp.

(16) ns_{MOL} refers to the negative electrode change rate of the adjusted negative electrode profile Rn'. Specifically, ns_{MOL} refers to the change rate of the adjusted negative electrode profile Rn' with respect to the reference negative electrode profile Rn.

(17) Diff_{ref} refers to a preset reference difference value. Specifically, the reference difference value may be set as the difference between the first reference feature value (pi_{BOL}) and the second reference feature value (pf_{BOL}) or the difference between the third reference feature value (ni_{BOL}) and the fourth reference feature value (nf_{BOL}). That is, the difference between the first reference feature value (pi_{BOL}) and the second reference feature value (pf_{BOL}) and the difference between the third reference feature value (ni_{BOL}) and the fourth reference feature value (nf_{BOL}) are the same. Hereinafter, for convenience of explanation, the reference difference value is referred to as Diff_{ref}.

(18) Preferably, if the first feature value (pi_{MOL}) is a value calculated for the capacity of the adjusted positive electrode profile Rp', the first reference feature value (pi_{BOL}) may also be a value calculated for the capacity of the reference positive electrode profile Rp. If the first feature value (pi_{MOL}) is a value calculated for the capacity of the adjusted negative electrode profile Rn', the first reference feature value (pi_{BOL}) may also be a value calculated for the capacity of the reference negative electrode profile Rn. If the first feature value (pi_{MOL}) is a value calculated for the capacity of the battery profile M, the first reference feature value (pi_{BOL}) may also be a value calculated for the capacity of the reference full-cell profile R.

Below, an example is described in which the control unit 130 diagnoses the state of the battery as an available lithium loss state.

The control unit 130 may be configured to determine a first feature value (pi_{MOL}) from the adjusted positive electrode profile Rp'.

For example, in the embodiment of FIG. 2, the control unit 130 may determine the first feature point (pi') from the adjusted positive electrode profile Rp'. Further, the control unit 130 may determine the first feature value (pi_{MOL}) based on the SOC of the first feature point (pi').

The control unit 130 may be configured to calculate an available lithium loss rate (Loss_{Li}) based on a first feature value (pi_{MOL}), a preset first reference feature value (pi_{BOL}), and a preset reference difference value.

Here, the first reference feature value (pi_{BOL}) and the reference difference value (Diff_{ref}) are as described above.

Specifically, the control unit 130 may calculate the available lithium loss rate (Loss_{Li}) based on the first feature value (pi_{MOL}), the first reference feature value (pi_{BOL}), and the reference difference value (Diff_{ref}).

For example, in the embodiment of FIG. 4, the control unit 130 may calculate the available lithium loss rate (Loss_{Li}) by dividing the difference between the first feature value (pi_{MOL}) and the first reference feature value (pi_{BOL}) by the reference difference value (Diff_{ref}).

The control unit 130 may be configured to compare the available lithium loss rate (Loss_{Li}) with a preset first threshold value.

Here, the first threshold value is a preset reference value that may determine whether the available lithium loss rate (Loss_{Li}) belongs to a normal state. For example, the first threshold value may be preset experimentally and/or theoretically. Preferably, the first threshold value may be preset by considering the type and state (deterioration degree, etc.) of the battery.

Specifically, the control unit 130 may directly compare the available lithium loss rate (Loss_{Li}) with the first threshold value. For example, the control unit 130 may compare the size of the available lithium loss rate (Loss_{Li}) with the first threshold value.

The control unit 130 may be configured to diagnose the state of the battery as an available lithium loss state based on the comparison result.

For example, the control unit 130 may diagnose the state of the battery as an available lithium loss state if the available lithium loss rate (Loss_{Li}) exceeds the first threshold value. That is, the control unit 130 may diagnose the state of the battery as an available lithium loss state if the available lithium of the battery is lost to an extent exceeding the first threshold value.

When available lithium is lost, the lost available lithium may be deposited as a metal on the surface of the negative electrode of the battery. The phenomenon of lithium being deposited as a metal is called lithium plating. Since this phenomenon causes an internal short circuit of the battery, it is the main cause of a battery fire and/or explosion. Therefore, the apparatus 100 for diagnosing a battery may non-destructively diagnose the state of the battery from the extracted diagnostic factor, thereby preventing an unexpected accident from occurring in advance.

Below, an example is described in which the control unit 130 diagnoses the state of the battery as a positive electrode loss state.

In one embodiment, the control unit 130 may be configured to determine a second feature value (pf_{MOL}) from the adjusted positive electrode profile Rp'.

For example, in the embodiment of FIG. 2, the control unit 130 may determine the second feature point (pf') corresponding to the positive electrode participation end point in the adjusted positive electrode profile Rp'. Then, the control unit 130 may determine the second feature value (pf_{MOL}) based on the capacity of the second feature point (pf').

The control unit 130 may be configured to calculate a positive electrode loss rate (Loss_{P}) based on the second feature value (pf_{MOL}), a preset second reference feature value (pf_{BOL}), and a preset reference difference value.

Here, the second reference feature value (pf_{BOL}) and the reference difference value (Diff_{ref}) are as described above.

Specifically, the control unit 130 may calculate the positive electrode loss rate (Loss_{P}) based on the second feature value (pf_{MOL}), the second reference feature value (pf_{BOL}), and the reference difference value (Diff_{ref}).

For example, in the embodiment of FIG. 4, the control unit 130 may calculate the positive electrode loss rate (Loss_{P}) by dividing the difference between the second feature value (pf_{MOL}) and the second reference feature value (pf_{BOL}) by the reference difference value (Diff_{ref}).

The control unit 130 may be configured to compare the positive electrode loss rate (Loss_{P}) with a preset second threshold value.

Here, the second threshold value is a preset reference value that may determine whether the positive electrode loss rate (Loss_{P}) belongs to the normal state. For example, the second threshold value may be preset experimentally and/or theoretically. Preferably, the second threshold value may be preset by considering the type and state (deterioration degree, etc.) of the battery.

Specifically, the control unit 130 may directly compare the positive electrode loss rate (Loss_{P}) and the second threshold value. For example, the control unit 130 may compare the size of the positive electrode loss rate (Loss_{P}) and the second threshold value.

The control unit 130 may be configured to diagnose the state of the battery as a positive electrode loss state based on the comparison result.

For example, the control unit 130 may diagnose the state of the battery as a positive electrode loss state if the positive electrode loss rate (Lossp) exceeds the second threshold value. That is, the control unit 130 may diagnose the state of the battery as a positive electrode loss state if the positive electrode of the battery is lost to an extent exceeding the second threshold value.

In another embodiment, the control unit 130 may be configured to calculate a positive electrode change rate (ps_{MOL}) of the adjusted positive electrode profile Rp'. And, the control unit 130 may be configured to calculate a positive electrode loss rate (Loss_{P}) based on the positive electrode change rate (ps_{MOL}) and a preset reference positive electrode change rate (ps_{BOL}).

Here, the reference positive electrode change rate (ps_{BOL}) and the positive electrode change rate (ps_{MOL}) are as described above.

Specifically, the control unit 130 may calculate the positive electrode loss rate (Loss_{P}) based on the reference positive electrode change rate (ps_{BOL}) and the positive electrode change rate (ps_{MOL}).

For example, in the embodiment of FIG. 4, the control unit 130 may calculate the positive electrode loss rate (Loss_{P}) by dividing the difference between the reference positive electrode change rate (ps_{BOL}) and the positive electrode change rate (ps_{MOL}) by the reference positive electrode change rate (ps_{BOL}).

That is, the apparatus 100 for diagnosing a battery may diagnose whether the state of the battery is a positive electrode loss state by calculating the positive electrode loss rate (Loss_{P}) in various ways.

Below, an example is described in which the control unit 130 diagnoses the state of the battery as a negative electrode loss state.

The control unit 130 may be configured to calculate a negative electrode change rate (ns_{MOL}) of the adjusted negative electrode profile Rn'. In addition, the control unit 130 may be configured to calculate a negative electrode loss rate (Loss_{N}) based on the negative electrode change rate (ns_{MOL}) and a preset reference negative electrode change rate (ns_{BOL}).

Here, the reference negative electrode change rate (ns_{BOL}) and the negative electrode change rate (ns_{MOL}) are as described above.

Specifically, the control unit 130 may calculate the negative electrode loss rate (Loss_{N}) based on the reference negative electrode change rate (ns_{BOL}) and the negative electrode change rate (ns_{MOL}).

For example, in the embodiment of FIG. 4, the control unit 130 may calculate the negative electrode loss rate (Loss_{N}) by dividing the difference between the reference negative electrode change rate (ns_{BOL}) and the negative electrode change rate (ns_{MOL}) by the reference negative electrode change rate (ns_{BOL}).

The control unit 130 may be configured to compare the negative electrode loss rate (Loss_{N}) with a preset third threshold value.

Here, the third threshold value is a preset reference value that may determine whether the negative electrode loss rate (Loss_{N}) belongs to the normal state. For example, the third threshold value may be preset experimentally and/or theoretically. Preferably, the third threshold value may be preset by considering the type and state (deterioration degree, etc.) of the battery.

Specifically, the control unit 130 may directly compare the negative electrode loss rate (Loss_{N}) and the third threshold value. For example, the control unit 130 may compare the size of the negative electrode loss rate (Loss_{N}) and the third threshold value.

The control unit 130 may be configured to diagnose the state of the battery as a negative electrode loss state based on the comparison result.

For example, the control unit 130 may diagnose the state of the battery as a negative electrode loss state if the negative electrode loss rate (Loss_{N}) exceeds the third threshold value. That is, the control unit 130 may diagnose the state of the battery as a negative electrode loss state if the negative electrode of the battery is lost to an extent exceeding the third threshold value.

Below, an example is described in which the control unit 130 diagnoses the state of a battery as a capacity loss state.

In one embodiment, the control unit 130 may be configured to determine a first feature value (pi_{MOL}) and a second feature value (pf_{MOL}) from the adjusted positive electrode profile Rp'. In addition, the control unit 130 may be configured to calculate a capacity loss rate (Loss_{Q}) based on the first feature value (pi_{MOL}), the second feature value (pf_{MOL}) and a preset reference difference value.

Here, the first feature value (pi_{MOL}), the second feature value (pf_{MOL}), and the reference difference value (Diff_{ref}) are as described above.

Specifically, the control unit 130 may calculate the capacity loss rate (Loss_{Q}) based on the first feature value (pi_{MOL}), the second feature value (pf_{MOL}), and the reference difference value (Diff_{ref}).

For example, in the embodiment of FIG. 4, the control unit 130 may calculate a positive electrode difference value (pf_{MOL} - pi_{MOL}) by calculating the difference between the first feature value (pi_{MOL}) and the second feature value (pf_{MOL}). Then, the control unit 130 may calculate a capacity loss rate (Loss_{Q}) by dividing the difference between the reference difference value (Diff_{ref}) and the positive electrode difference value (pf_{MOL} - pi_{MOL}) by the reference difference value (Diff_{ref}).

The control unit 130 may be configured to compare the capacity loss rate (Loss_{Q}) with a preset fourth threshold value.

Here, the fourth threshold value is a preset reference value that may determine whether the capacity loss rate (Loss_{Q}) belongs to the normal state. For example, the fourth threshold value may be preset experimentally and/or theoretically. Preferably, the fourth threshold value may be preset by considering the type and state (deterioration degree, etc.) of the battery.

Specifically, the control unit 130 may directly compare the capacity loss rate (Loss_{Q}) and the fourth threshold value. For example, the control unit 130 may compare the size of the capacity loss rate (Loss_{Q}) and the fourth threshold value.

The control unit 130 may be configured to diagnose the state of the battery as a capacity loss state based on the comparison result.

For example, the control unit 130 may diagnose the state of the battery as a positive electrode loss state if the capacity loss rate (Loss_{Q}) exceeds the fourth threshold value. That is, the control unit 130 may diagnose the state of the battery as a positive electrode loss state if the positive electrode of the battery is lost to an extent exceeding the fourth threshold value.

In another embodiment, the control unit 130 may be configured to determine a third feature value (ni_{MOL}) and a fourth feature value (nf_{MOL}) from the adjusted negative electrode profile Rn'. And, the control unit 130 may be configured to calculate a capacity loss rate (Loss_{Q}) based on the third feature value (ni_{MOL}), the fourth feature value (nf_{MOL}) and a preset reference difference value.

Here, the third feature value (ni_{MOL}), the fourth feature value (nf_{MOL}), and the reference difference value (Diff_{ref}) are as described above.

Specifically, the control unit 130 may calculate the capacity loss rate (Loss_{Q}) based on the third feature value (ni_{MOL}), the fourth feature value (nf_{MOL}), and the reference difference value (Diff_{ref}).

For example, in the embodiment of FIG. 4, the control unit 130 may calculate the negative electrode difference value (nf_{MOL} - ni_{MOL}) by calculating the difference between the third feature value (ni_{MOL}) and the fourth feature value (nf_{MOL}). Then, the control unit 130 may calculate the capacity loss rate (Loss_{Q}) by dividing the difference between the reference difference value (Diff_{ref}) and the negative electrode difference value (nf_{MOL} - ni_{MOL}) by the reference difference value (Diff_{ref}).

That is, the apparatus 100 for diagnosing a battery may diagnose whether the battery is in a capacity loss state by calculating the capacity loss rate (Loss_{Q}) in various ways.

Below, an example in which control unit 130 diagnoses the state of the battery as a normal state is described.

Specifically, the control unit 130 may diagnose the state of the battery as a normal state if the state of the battery is not an available lithium loss state, a positive electrode loss state, a negative electrode loss state, or a capacity loss state.

That is, the control unit 130 may diagnose the state of the battery as a normal state if the available lithium loss rate (Loss_{Li}) is equal to or less than the first threshold value, the positive electrode loss rate (Loss_{P}) is equal to or less than the second threshold value, the negative electrode loss rate (Loss_{N}) is equal to or less than the third threshold value, and the capacity loss rate (Loss_{Q}) is equal to or less than the fourth threshold value.

The apparatus 100 for diagnosing a battery according to an embodiment of the present disclosure may conservatively set the case where the state of the battery is diagnosed as a normal state. That is, the state of the battery may be diagnosed as a normal state only when all the diagnosis results using the four degradation parameters are positive. Therefore, the apparatus 100 for diagnosing a battery may strictly detect a battery exhibiting abnormal behavior, thereby preventing unexpected accidents from occurring due to abnormal behavior in advance.

Additionally, the control unit 130 may be configured to change preset usage conditions for the battery based on the diagnostic results.

For example, the control unit 130 may appropriately change at least one of the maximum allowable temperature, the maximum C-rate, the upper limit voltage (or the upper limit SOC), and the lower limit voltage (or the lower limit SOC) to correspond to the state of the battery.

For example, the upper limit voltage may refer to the maximum allowable voltage to which the battery can be charged (e.g. without causing damage or degradation). Similarly, the upper limit SOC may refer to the maximum allowable percentage of the battery's charge capacity (e.g., 100% SOC corresponds to a fully charged battery). For example, the upper limit voltage/SOC may be reduced if the battery shows signs of degradation, such as lithium plating, electrode damage, or reduced capacity, to prevent further stress and maintain safety. Operating the battery below this adjusted threshold may help mitigating risks such as overheating, overcharging, or accelerated aging.

For example, the lower limit voltage may refer to the minimum allowable voltage to which the battery can be discharged (e.g. before the risk of damage increases). For example, the lower limit SOC may represent the lowest acceptable percentage of the battery's charge capacity (e.g., 0% SOC corresponds to a fully discharged battery). For example, the lower limit voltage/SOC may be increased if the battery shows signs of capacity loss or increased internal resistance, to prevent excessive depth of discharge, which can lead to accelerated wear, loss of active material, or failure.

In summary, the upper limit voltage (or SOC) and lower limit voltage (or SOC) may define the safe operating boundaries for the battery. These limits may be adjusted dynamically to correspond to the battery's state of health, ensuring safe operation, extending lifespan, and mitigating risks associated with overcharging or deep discharging. That is, according to an embodiment of the present disclosure, the apparatus 100 for diagnosing a battery may prevent the state of the battery from further deteriorating by changing the usage conditions of the battery based on the strictly diagnosed state of the battery. In addition, the apparatus 100 for diagnosing a battery may increase the expected life of the battery by appropriately changing the usage conditions to correspond to the state of the battery. As a practical example, suppose a battery in its early life operates safely between 3.0 V (lower limit) and 4.2 V (upper limit). After diagnosing a loss of lithium inventory or electrode capacity degradation, the diagnostic system may adjust the operating range to 3.2 V and 4.0 V to reduce stress on the electrodes and prolong the battery's usability.

The apparatus 100 for diagnosing a battery according to the present disclosure may be used in or as a part of a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the profile adjusting unit 120, the control unit 130 and the storage unit 140 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 5 is a drawing schematically showing a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a battery profile M based on the battery information.

As another example, the profile obtaining unit 110 may receive the battery profile M from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 6 is a drawing schematically showing a vehicle 600 according to still another embodiment of the present disclosure.

Referring to FIG. 6, the battery pack 610 according to the embodiment of the present disclosure may be included in a vehicle 600, such as an electric vehicle (EV) or a hybrid vehicle (HV). In addition, the battery pack 610 may drive the vehicle 600 by supplying power to a motor through an inverter provided in the vehicle 600. Here, the battery pack 610 may include the apparatus 100 for diagnosing a battery. That is, the vehicle 600 may include the apparatus 100 for diagnosing a battery. In this case, the apparatus 100 for diagnosing a battery may be an onboard device included in the vehicle 600.

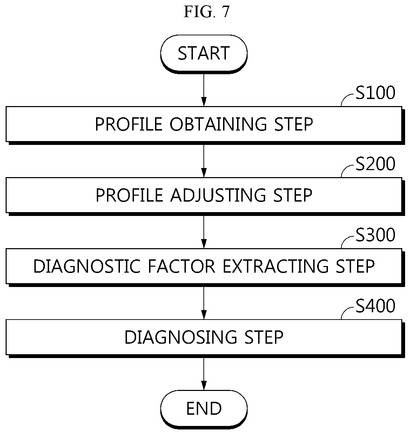

FIG. 7 is a diagram schematically showing a method for diagnosing a battery according to still another embodiment of the present disclosure.

Referring to FIG. 7, the method for diagnosing a battery may include a profile obtaining step (S100), a profile adjusting step (S200), a diagnostic factor extracting step (S300), and a diagnosing step (S400).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining a battery profile M representing a correspondence relationship between voltage and capacity of a battery. The profile obtaining step (S100) may be performed by the profile obtaining unit 110.

For example, the profile obtaining unit 110 may directly receive the battery profile M from the outside. That is, the profile obtaining unit 110 may obtain the battery profile M by being connected to the outside via wire and/or wirelessly and receiving the battery profile M.

As another example, the profile obtaining unit 110 may receive battery information about the voltage and capacity of the battery. Then, the profile obtaining unit 110 may generate a battery profile M based on the received battery information. That is, the profile obtaining unit 110 may obtain the battery profile M by directly generating the battery profile M based on the battery information.

The profile adjusting step (S200) is a step of adjusting a preset reference positive electrode profile Rp and a reference negative electrode profile Rn to correspond to the battery profile M to generate an adjusted positive electrode profile Rp' and an adjusted negative electrode profile Rn'. The profile adjusting step (S200) may be performed by the profile adjusting unit 120.

For example, the profile adjusting unit 120 may generate a plurality of comparison profiles by shifting or capacity-scaling the reference positive electrode profile Rp and the reference negative electrode profile Rn, and specify a comparison profile among the plurality of comparison profiles that has a minimum error with respect to the battery profile M. Then, the profile adjusting unit 120 may determine an adjusted positive electrode profile Rp' corresponding to the specified comparison profile as the positive electrode profile of the battery. Then, the profile adjusting unit 120 may determine an adjusted negative electrode profile Rn' corresponding to the specified comparison profile as the negative electrode profile of the battery.

The diagnostic factor extracting step (S300) is a step of extracting a diagnostic factor for the battery from at least one of the adjusted positive electrode profile Rp' and the adjusted negative electrode profile Rn'. The diagnostic factor extracting step (S300) may be performed by the control unit 130.

For example, the control unit 130 may extract at least one of the first feature value (pi_{MOL}), the second feature value (pf_{MOL}), the third feature value (ni_{MOL}), the fourth feature value (nf_{MOL}), the positive electrode change rate (ps_{MOL}), and the negative electrode change rate (ns_{MOL}) as a diagnostic factor.

The diagnosing step (S400) is a step of diagnosing the state of the battery based on the extracted diagnostic factor. The diagnosing step (S400) may be performed by the control unit 130.

For example, the control unit 130 may be configured to calculate a degradation parameter including at least one of an available lithium loss rate (Loss_{Li}), a positive electrode loss rate (Loss_{P}), a negative electrode loss rate (Loss_{N}), and a capacity loss rate (Loss_{Q}) based on the extracted diagnostic factor.

In addition, the control unit 130 may be configured to diagnose the state of the battery based on the generated degradation parameter. For example, the control unit 130 may diagnose the state of the battery as at least one of an available lithium loss state, a positive electrode loss state, a negative electrode loss state, a capacity loss state, and a normal state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measuring unit
100: apparatus for diagnosing a battery
110: profile obtaining unit
120: profile adjusting unit
130: control unit
140: storage unit
600: vehicle
610: battery pack.

## Claims

1. An apparatus for diagnosing a battery, comprising:
a profile obtaining unit configured to obtain a battery profile representing a correspondence relationship between a voltage and a capacity of the battery;
a profile adjusting unit configured to adjust a preset reference positive electrode profile and a preset reference negative electrode profile to correspond to the battery profile to generate an adjusted positive electrode profile and an adjusted negative electrode profile; and
a control unit configured to extract a diagnostic factor for the battery from at least one of the adjusted positive electrode profile and the adjusted negative electrode profile and to diagnose a state of the battery based on the extracted diagnostic factor.

2. The apparatus for diagnosing a battery according to claim 1,
wherein the control unit is configured to determine a degradation parameter of the battery, the degradation parameter including at least one of an available lithium loss rate, a positive electrode loss rate, a negative electrode loss rate, and a capacity loss rate based on the extracted diagnostic factor and to diagnose the state of the battery based on the calculated degradation parameter.

3. The apparatus for diagnosing a battery according to claim 2,
wherein the control unit is configured to determine a first feature value from the adjusted positive electrode profile and to determine the available lithium loss rate based on the first feature value, a preset first reference feature value, and a preset reference difference value.

4. The apparatus for diagnosing a battery according to claim 2,
wherein the control unit is configured to compare the available lithium loss rate with a preset first threshold value and to diagnose the state of the battery as an available lithium loss state based on the comparison result.

5. The apparatus for diagnosing a battery according to claim 2,
wherein the control unit is configured to determine a second feature value from the adjusted positive electrode profile and to determine the positive electrode loss rate based on the second feature value, a preset second reference feature value, and a preset reference difference value.

6. The apparatus for diagnosing a battery according to claim 2,
wherein the control unit is configured to calculate a positive electrode change rate of the adjusted positive electrode profile and to determine the positive electrode loss rate based on the positive electrode change rate and a preset reference positive electrode change rate.

7. The apparatus for diagnosing a battery according to claim 2,
wherein the control unit is configured to compare the positive electrode loss rate with a preset second threshold value and to diagnose the state of the battery as a positive electrode loss state based on the comparison result.

8. The apparatus for diagnosing a battery according to claim 2,
wherein the control unit is configured to calculate a negative electrode change rate of the adjusted negative electrode profile and to determine the negative electrode loss rate based on the negative electrode change rate and a preset reference negative electrode change rate.

9. The apparatus for diagnosing a battery according to claim 2,
wherein the control unit is configured to compare the negative electrode loss rate with a preset third threshold value and to diagnose the state of the battery as a negative electrode loss state based on the comparison result.

10. The apparatus for diagnosing a battery according to claim 2,
wherein the control unit is configured to determine a first feature value and a second feature value from the adjusted positive electrode profile and to determine the capacity loss rate based on the first feature value, the second feature value, and a preset reference difference value.

11. The apparatus for diagnosing a battery according to claim 2,
wherein the control unit is configured to determine a third feature value and a fourth feature value from the adjusted negative electrode profile and to determine the capacity loss rate based on the third feature value, the fourth feature value, and a preset reference difference value.

12. The apparatus for diagnosing a battery according to claim 2,
wherein the control unit is configured to compare the capacity loss rate with a preset fourth threshold value and to diagnose the state of the battery as a capacity loss state based on the comparison result.

13. A battery pack, comprising the apparatus for diagnosing a battery according to any one of claims 1 to 12.

14. A vehicle, comprising the apparatus for diagnosing a battery according to any one of claims 1 to 12.

15. A method for diagnosing a battery, comprising:
a profile obtaining step of obtaining a battery profile representing a correspondence relationship between voltage and capacity of a battery;
a profile adjusting step of adjusting a preset reference positive electrode profile and a reference negative electrode profile to correspond to the battery profile to generate an adjusted positive electrode profile and an adjusted negative electrode profile;
a diagnostic factor extracting step of extracting a diagnostic factor for the battery from at least one of the adjusted positive electrode profile and the adjusted negative electrode profile; and
a diagnosing step of diagnosing a state of the battery based on the extracted diagnostic factor.
